# EUROPEAN PATENT SPECIFICATION

(11) **EP 4 082 694 B1**
(45) Date of publication and mention of the grant of the patent: **21.10.2026**
(21) Application number: 20907092.9
(22) Date of filing: 12.11.2020
(51) Int. Cl.: B22F 5/10, B22F 5/12, C03C 8/16, B33Y 10/00, B33Y 80/00, C23C 26/00, F16L 58/14, F16L 9/02, F16L 9/14, C03C 4/20, B05D 7/22, B22F 10/62, C03C 3/066, C03C 3/091, C03C 3/21, C23D 5/02, C03C 3/17, B22F 10/25, B22F 10/28

(54) **METAL LAMINATE MOLDING FLOW PATH MEMBER AND MANUFACTURING METHOD THEREFOR**
METALLLAMINAT-FLIESSWEGELEMENT UND HERSTELLUNGSVERFAHREN DAFÜR
ÉLÉMENT DE TRAJET D'ÉCOULEMENT DE MOULAGE DE STRATIFIÉ MÉTALLIQUE ET SON PROCÉDÉ DE FABRICATION

(30) Priority: 26.12.2019 JP 2019236278; 11.08.2020 JP 2020135834
(43) Date of publication of application: 02.11.2022
(73) Proprietor: Proterial, Ltd., Tokyo 135-0061 (JP)
(72) Inventor: MIYATA, Motoyuki, Tokyo 100-8280 (JP); AOYAGI, Takuya, Tokyo 100-8280 (JP); DAIGO, Yuzo, Tokyo 108-8224 (JP); MIYAKE, Tatsuya, Tokyo 100-8280 (JP); NAITO, Takashi, Tokyo 100-8280 (JP)
(74) Representative: Strehl & Partner mbB
(86) International application number: PCT/JP2020/042272
(87) International publication number: WO 2021/131379

(56) References cited:
- GB-A- 585 257
- JP-A- 2004 075 491
- JP-A- 2006 347 827
- JP-A- 2007 119 875
- JP-A- 2011 219 325
- JP-A- 2013 256 437
- JP-A- 2014 113 610
- JP-A- S6 159 087

## Description

### Technical Field

The present invention relates to a technology of a flow path member in which to distribute a corrosive fluid (gas or liquid) used in a semiconductor device manufacturing process or the like, particularly to a metallic laminate shaped flow path member manufactured using a metallic laminate shaping method.

### Background Art

High integration technologies for semiconductor devices have continued to develop, and the wiring pitch of circuitry has become smaller and smaller. For securing a high production yield in such semiconductor devices, for example, precision control of supply gas amount in the manufacturing process and cleaning of a supply gas line are indispensable technologies.

In precision control of the supply gas amount and cleaning of the supply gas line, surface smoothness of an inner surface (also called a gas contact surface) of the gas flow path is one of very important factors. As a reason for this, the following events may be exemplified.

In the case where the surface smoothness of the gas flow path gas contact surface is poor (surface roughness is large), (1) a gas flow in the immediate vicinity of the gas contact surface is liable to be disturbed and control accuracy of gas flow rate is liable to be lowered, (2) actual surface area of the gas contact surface is enlarged, gas adsorption amount is increased, vacuum reaching time of the semiconductor device manufacturing apparatus is elongated, and productivity is liable to be lowered, and (3) when undesired particles are once deposited on the gas contact surface (for example, when the undesired particles are trapped in a large valley), it is difficult to completely remove the particles by gas line cleaning, and the like may be exemplified.

From the aforementioned reasons, the flow path member used as the supply gas line of the semiconductor device manufacturing apparatus needs the arithmetic mean roughness Ra of the gas contact surface to be equal to or less than 0.4 µm.

On the other hand, in the semiconductor device manufacturing process, corrosive gases (for example, HF (hydrogen fluoride), HCl (hydrogen chloride), Cl₂ (chlorine), ClF₃ (chlorine trifluoride), HBr (hydrogen bromide), and the like) are often used, and, as a flow path member through which to distribute such a corrosive gas, highly corrosion resistant metallic materials (for example, stainless steel, Ni (nickel)-Cr (chromium)-Mo (molybdenum) based alloys, and the like) have hitherto been used.

However, even if the flow path member is constituted of a highly corrosion resistant metallic material, it may be corroded when exposed to a corrosive gas for a long time, and surface roughness of the gas contact surface may be increased due to the progress of corrosion, or a corrosion reaction product may become a generation source of particles. This lowers the production yield of the semiconductor devices and has been a problem requiring a countermeasure.

In view of such a problem, for example, Patent Document 1 (JP-1995-281759-A) discloses a mass flow controller including an inflow path for a fluid, a bypass flow path in which the fluid from the inflow path flows, a sensor flow path which is branched from the bypass flow path and through which fluids of predetermined flow rate ratio flow, a flow rate sensor that measures the flow rate of the fluid flowing through the sensor flow path, an outflow path through which the fluids in the bypass flow path and the sensor flow path flow by joining each other, a flow rate control valve provided in the outflow path, and a comparative control section that compares a detection signal detected by the flow rate sensor and a preset signal and, based on the comparison result, controls the flow rate control valve. The bypass flow path and/or the sensor flow path is formed of one metallic material among nickel, platinum, nickel-based alloy, copper, and copper alloy.

Patent Document 1 states that it is possible to provide a mass flow controller in which corrosion resistance performance of a sensor pipe and a bypass pipe liable to be corroded by a halogen based gas or the like is enhanced and generation of particles is prevented by restraining reaction products.

On the other hand, in the fluid supply line used in the semiconductor device manufacturing process, there are members and devices configuring a flow path in a complicated shape (for example, a branched flow path, a joining flow path, a constriction flow path, a spiral flow path, and combinations of them) in many cases. Such members and devices involve difficult processing and are therefore expensive, which is one of causes of high cost in building up the fluid supply line.

As a solution to such a problem, in recent years, as a technology for manufacturing final products having a complicated shape on a near-net shape/net shape basis, a three-dimensional shaping technology (what is generally called 3D printing) such as a metallic laminate shaping method (also referred to as Metal Additive Manufacturing) has been paid attention to.

For example, Patent Document 2 (JP-2018-170205-A) discloses a method of manufacturing a fluid heater including a flow path member formed with a flow path, a heater for heating the flow path member, a fixing member for fixing the flow path member to a fluid control device, and a connection pipe which is connected to the flow path member and is for causing a fluid to flow into the flow path member, the flow path being spiral in shape, the shape of a section taken along a longitudinal direction thereof being polygonal. The method of manufacturing the fluid heater includes a step of forming the flow path member by a metallic powder sintering shaping system and a step of combining the heater, the fixing member, and the connection pipe with the flow path member.

Patent Document 2 states that, for suppressing increase in the size of a fluid heater and a fluid control apparatus, it is possible to provide a fluid heater capable of enhancing heating efficiency of a fluid (thereby to permit reduction in size), a fluid control apparatus, and a method of manufacturing the fluid heater.

Fluoric acid-proof glass compositions are disclosed in the documents GB 585 257 A, JP 2004-075491 A. The document JP 2006-347827 A discloses steel substrates coated with smooth amorphous SiO₂ films.

### Prior Art Document

### Patent Document

Patent Document 1: JP-1995-281759-A
Patent Document 2: JP-2018-170205-A

### Summary of the Invention

### Problem to be Solved by the Invention

As aforementioned, the metallic laminate shaping technology can manufacture final products on a near-net shape/net shape basis, and therefore, it is expected that even a flow path member having a complicated shape can be manufactured at a high production yield and stably (in other words, at low cost).

However, an article as formed by the present metallic laminate shaping technology has a problem that the surface roughness is comparatively large (for example, Ra = 5 to 50 µm). This surface roughness is one to two places of magnitude greater than the level (Ra ≤ 0.4 µm) required for the flow path member to be used in a supply gas line of the semiconductor device manufacturing apparatus. In view of this, it may be considered to polish the surface to thereby adjust the surface roughness, but polishing becomes more difficult as the shape is more complicated.

Accordingly, it is an object of the present invention to provide a metallic laminate shaped flow path member having both a surface roughness of a flow path inner surface and corrosion resistance at such a level as to be utilizable as a flow path member to be used in a supply line for a corrosive fluid, and a method of manufacturing the same.

### Means for Solving the Problem

(I) In accordance with an aspect of the present invention, there is provided a metallic laminate shaped flow path member according to claim 1 through which to distribute a corrosive fluid, in which a metallic substrate constituting the metallic laminate shaped flow path member has surface irregularities, an inner surface of a flow path wall of the metallic laminate shaped flow path member is formed with a glass coating layer in such a manner as to fill at least recessed regions of the surface irregularities of the metallic substrate, and the glass coating layer includes at a layer of a P₂O₅ (phosphorus oxide)-ZnO (zinc oxide)-Al₂O₃ (aluminum oxide) based glass.
   Note that, in the present invention, "··· based" means sequential enumeration of highercontent components, and other components than the enumerated may be contained.
(II) In accordance with another aspect of the present invention, there is provided a method of manufacturing the above-described metallic laminate shaped flow path member as defined in claim 6, the method including a metallic laminate shaping step of forming the metallic substrate by a metallic laminate shaping method, and a glass coating layer forming step of forming the glass coating layer on the inner surface of the flow path wall. The glass coating layer forming step includes a glass paste preparing step of preparing a glass paste in which a powder of the glass, a resin binder, and an organic solvent are mixed, and a glass paste applying and baking step of applying the glass paste on the inner surface of the flow path wall and heat treating the glass paste together with the metallic substrate to bake the glass coating layer. The temperature of the heat treatment in the glass paste applying and baking step is equal to or more than a softening point temperature of the glass in the glass paste and equal to or less than 700°C.

In the present invention, the following improvement or modification can be added to the method (II) of manufacturing the metallic laminate shaped flow path member described above.

(x) The glass paste has a content of the resin binder based on the total of the organic solvent and the resin binder being 3 to 13 mass%, and a content of the powder of the glass in the glass paste is 10 to 90 mass%.

### Advantage of the Invention

According to the present invention, it is possible to provide a metallic laminate shaped flow path member having both a surface roughness of a flow path inner surface and corrosion resistance at such a level as to be utilizable as a flow path member to be used in a supply line for a corrosive fluid, and a method of manufacturing the same.

### Brief Description of the Drawings

FIG. 1 is a sectional schematic view depicting an example of a metallic laminate shaped flow path member according to the present invention.
FIG. 2 is a flow chart depicting an example of a method of manufacturing a metallic laminate shaped flow path member according to the present invention.
FIG. 3 is a photograph of a microstructure of a flow path wall inner surface of a metallic substrate on which a glass coating has not been formed.
FIG. 4 is a photograph of a microstructure of a flow path wall inner surface of an example of the metallic laminate shaped flow path member on which a glass coating layer has been formed.

### Mode for Carrying Out the Invention

### (Basic Thought of Present Invention)

As aforementioned, articles formed by the present metallic laminate shaping technology have a problem that surface roughness is large if not subjected to polishing. In the case of a complicated flow path shape, if the inner surface is to be subjected to electrolytic polishing similarly to a conventional metallic pipe, setting itself of a counter electrode that should be set in the flow path is very difficult to achieve. In addition, since a highly corrosion resistant metallic material is used as a flow path member, chemical polishing is also unsuitable. Besides, in the case of a flow path of a complicated shape, physical polishing of the flow path inner surface is extremely difficult to perform.

In view of this, the present inventors have investigated not smoothening by scraping off projected parts of surface irregularities of a metallic laminate shaped body but smoothening by forming a coating layer in such a manner as to fill recessed parts of the surface irregularities. Particularly, they have found out that glass coating is suitable from the viewpoint of applicability to the surface of a metallic substrate, the viewpoint of corrosion resistance to corrosive fluids, and the viewpoint of heat resistance required of a flow path member.

As a result of investigation of suitability of a glass coating layer, they have found out that, by forming a coating layer of a P₂O₅-ZnO-Al₂O₃ based glass, a Bi₂O₃-ZnO-B₂O₃ based glass, or an SiO₂-B₂O₃-Na₂O based glass, the surface can be smoothened to have an arithmetic mean roughness "Ra ≤ 0.4 µm," and corrosion resistance to halogen based corrosive gases (particularly, HF, HCl, and/or HBr) and heat resistance can both be secured. Further, they have found out that, as a P₂O₅-ZnO-Al₂O₃ based glass, a P₂O₅-ZnO-Al₂O₃-(AM)₂O glass and a P₂O₅-ZnO-Al₂O₃-(AEM)O glass are preferable, and a P₂O₅-ZnO-Al₂O₃-(AM)₂P glass is particularly preferable. The present invention is based on the findings.

### (Metallic Laminate Shaping Method)

By the aforementioned technology of laminate shaping called 3D printing, it has become possible to shape a complicated shaped body at low cost. By supplying thermal energy to a raw material powder to repeat melting and solidifying the raw material powder (hereinafter referred to as melting and solidifying), a laminate shaped body of a three-dimensional shape of near-net shape/net shape can be obtained. The metallic laminate shaping method in which a metallic material is an object can be largely classified into a powder bed system and a powder deposition system. The metallic laminate shaped flow path member in the present invention can be shaped by either of the two systems.

The powder bed system is a method in which a metallic powder is spread all over to prepare a powder bed and a laser beam or an electron beam serving as thermal energy is applied to melt and solidify or sinter only a part to be shaped. The method in which a laser beam is used as a heat source and the part to be shaped of the powder bed is melted and solidified is referred to as a selective laser melting method (SLM). In addition, the method in which the part to be shaped of the powder bed is not melted but is sintered is referred to as a selective laser sintering method (SLS). In the method in which a laser beam is used as a heat source, an inactive atmosphere such as nitrogen and argon is generally used. The method in which an electron beam is used as a heat source in the powder bed system is referred to as a selective electron beam melting method (SEBM) or simply as an electron beam melting method (EBM). In the case where the electron beam is used as a heat source, a high vacuum environment is used.

On the other hand, the powder deposition system is a method in which a laser beam or an electron beam is used as a heat source, a metallic powder is continuously supplied into the beam or to a beam application position, and the metallic powder is melted and solidified along the application locus of the beam, thereby shaping. The atmosphere and environment during the shaping are similar to those of the powder bed system. The powder deposition system has an advantage that it is easy to control the amount of powder supplied and high-speed shaping is possible.

### (Metallic Laminate Shaped Flow Path Member)

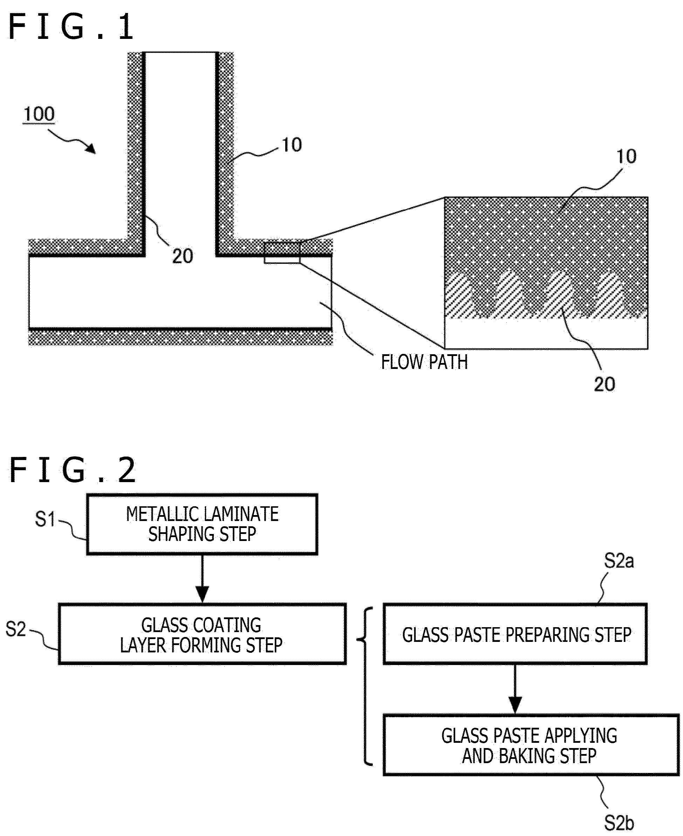

FIG. 1 is a sectional schematic view depicting an example of a metallic laminate shaped flow path member according to the present invention. As depicted in FIG. 1, the metallic laminate shaped flow path member 100 according to the present invention has a metallic substrate 10, and a glass coating layer 20 formed on an inner surface of a flow path wall constituting a flow path.

Since the metallic substrate 10 is produced by use of a metallic laminate shaping technology, the surface is generally largely based on the particle diameter of a metallic powder and production conditions, and irregularities having an arithmetic mean roughness Ra on the order of 5 to 50 µm are generated. The glass coating layer 20 is formed in such a manner as to fill at least recessed regions of the surface irregularities. As a result, the arithmetic mean roughness Ra of the flow path wall inner surface is equal to or less than 0.4 µm. The arithmetic means roughness Ra is more preferably equal to or less than 0.2 µm.

In other words, though a smaller arithmetic mean roughness Ra of the flow path wall inner surface is more preferable, it is sufficient that the glass coating layer 20 is formed such that the arithmetic mean roughness Ra is equal to or less than 0.4 µm. Projected regions of the surface irregularities of the metallic substrate 10 are preferably configured such that all the peaks thereof are covered with the glass coating layer 20. Note that, in the case where the metallic substrate 10 itself includes a metallic material (for example, a super-corrosion-resistant alloy material) having a sufficient corrosion resistance to corrosive fluids to be distributed, all the peaks may not be covered with the glass coating layer 20, on the assumption that the flow path wall inner surface satisfies "Ra ≤ 0.4 µm."

In addition, the metallic laminate shaped flow path member 100 according to the present invention is not limited in formation of the glass coating layer 20 to only the flow path wall inner surface, and the glass coating layer 20 may be formed on a flow path wall outer surface in addition to the flow path wall inner surface.

As the glass constituting the glass coating layer 20, the invention proposes a P₂O₅-ZnO-Al₂O₃ based glass and a Bi₂O₃-ZnO-B₂O₃ based glass, or an SiO₂-B₂O₃-Na₂O based glass is related art. Specifically, a P₂O₅-ZnO-Al₂O₃ based glass and a Bi₂O₃-ZnO-B₂O₃ based glass are preferable for HF, while a P₂O₅-ZnO-Al₂O₃ based glass and an SiO₂-B₂O₃-Na₂O based glass are preferable for HCl and HBr. As the P₂O₅-ZnO-Al₂O₃ based glass, the invention proposes a P₂O₅-ZnO-Al₂O₃-(AM)₂O glass and a P₂O₅-ZnO-Al₂O₃-(AEM)O, and a P₂O₅-ZnO-Al₂O₃-(AM)₂O glass is particularly preferable.

More specifically, the chemical composition of the P₂O₅-ZnO-Al₂O₃ based glass is defined in claim 1.

The glass coating layer 20 can also be configured by combining (in such a manner as to laminate) one or more of the aforementioned glass layers. In the case of laminating the glass layers, it is preferable to use the glass layer which is the highest in corrosion resistance as the gas contact surface.

The flow path structure of the metallic laminate shaped flow path member of the present invention is not particularly limited, but, from the meaning of production by use of the metallic laminate shaping technology, it can be said that more effects are obtained in a complicated flow path structure (for example, a branched flow path, a joining flow path, a constriction flow path, a spiral flow path, and combinations thereof).

While the material of the metallic substrate 10 is not particularly limited, highly corrosion resistant alloy materials (for example, stainless steel such as SUS316L) and super-corrosion-resistant alloy materials (for example, HASTELLOY (registered trademark), a Ni-Cr-Mo based alloy in which the three highest content components are Ni, Cr, and Mo, a high entropy based alloy including Co-Cr-Fe-Ni-Ti, and the like) can preferably be used.

The device and apparatus using the metallic laminate shaped flow path member 100 of the present invention is also not particularly limited, and the metallic laminate shaped flow path member 100 can be preferably used for the device and apparatus to be used in the supply line of a corrosive fluid used in the semiconductor device manufacturing process (for example, a mass flow controller by which to distribute a corrosive gas, a mass flowmeter, a shut-off valve, a selector valve, a vaporizer, a fluid heater, and a piping unit obtained by combining these).

When the aforementioned glass coating layer is applied to such device or apparatus, for example, it is possible, in the case of a mass flow controller, to accurately control the flow rate of the gas. In addition, in the case of a semiconductor device manufacturing apparatus, the time for reaching a vacuum can be shortened. Further, it is possible to restrain deposition of particles on the flow path wall inner surface, and, even if the particles are deposited, it is easy to remove the particles by gas line cleaning.

### (Method of Manufacturing Metallic Laminate Shaped Flow Path Member)

Next, a method of manufacturing the metallic laminate shaped flow path member 100 according to the present invention will be described.

FIG. 2 is a flow chart depicting an example of the method of manufacturing a metallic laminate shaped flow path member according to the present invention. As depicted in FIG. 2, the method generally has a metallic laminate shaping step S1 of forming the metallic substrate 10 of the flow path member and a glass coating layer forming step S2 of forming the glass coating layer on the inner surface of the flow path wall of the metallic substrate 10. The glass coating layer forming step S2 has a glass paste preparing step S2a and a glass paste applying and baking step S2b.

The metallic laminate shaping step S1 is not particularly limited, and the aforementioned metallic laminate shaping method (for example, the selective laser melting method (SLM method), the laser metal deposition method (LMD method), and the electron beam melting method (EBM method)) can be used preferably, insofar as a metallic substrate 10 having a desired flow path structure is obtained.

The glass paste preparing step S2a is a step of mixing a predetermined glass powder, an organic solvent, and a resin binder to prepare a glass paste. The mixing method is not particularly limited, and an existing mixing method (for example, mixing by a planetary centrifugal mixer) may be used as required. Note that the step S2a is not limited to be performed after the step S1 and may be performed before the step S1. In addition, the step S2a is not a step indispensable to the manufacturing method according to the present invention, and a glass paste may be prepared by purchasing a glass paste blended to a desired configuration.

As the glass, as aforementioned, a P₂O₅-ZnO-Al₂O₃ based glass, a P₂O₅-ZnO-Al₂O₃-(AM)₂O glass or a P₂0₅-ZnO-Al₂O₃-(AEM)O glass is used according to the invention. It is preferable that the glass has a softening point temperature higher than the maximum temperature (for example, 300°C, more preferably 400°C) which the metallic laminate shaped flow path member experiences in the operation environment of the fluid supply line, and forms a coating layer at a temperature of equal to or less than 700°C. Note that 700°C is an upper limit temperature in the glass paste applying and baking step S2b as a subsequent step and is a reference temperature at which the metallic substrate 10 is not denatured.

The chemical composition of the glass will be described briefly.

P₂O₅, Bi₂O₃, SiO₂, and B₂O₃ are components capable of forming a skeleton of the glass. In the P₂O₅-ZnO-Al₂O₃-(AM)₂O glass and the P₂0₅-ZnO-Al₂O₃-(AEM)O glass, the content of P₂O₅ is 45 to 65 mol%, more preferably 51 to 63 mol%. By adjusting the P₂O₅ content to within the range, excellent corrosion resistance to halogen based corrosive substances is produced.

ZnO is a component for enhancing chemical stability of the glass and for supporting corrosion resistance. In the P₂O₅-ZnO-Al₂O₃-(AM)₂O glass and the P₂O₅-ZnO-Al₂O₃-(AEM)O glass, the content of ZnO is 10 to 25 mol%, more preferably 16 to 19 mol%. By adjusting the ZnO content to within the range, sufficient corrosion resistance to halogen based corrosive substances is produced, and an effect of restraining crystallization of the glass is produced.

Al₂O₃ is also a component for enhancing chemical stability of the glass and for supporting corrosion resistance. In the P₂O₅-ZnO-Al₂O₃-(AM)₂O glass and the P₂O₅-ZnO-Al₂O₃-(AEM)O glass, the content of Al₂O₃ is preferably 16 to 25 mol%, more preferably 16 to 19 mol%. By adjusting the Al₂O₃ content to within the range, sufficient corrosion resistance to halogen based corrosive substances is produced.

In the P₂O₅-ZnO-Al₂O₃-(AM)₂O glass and the P₂0₅-ZnO-Al₂O₃-(AEM)O glass, (AM)₂O and (AEM)O are components contributing to enhancement of corrosion resistance. The contents of these are 2 to 18 mol%, more preferably 6 to 14 mol%. By adjusting the (AM)₂O content and the (AEM)O content to within the range, sufficient corrosion resistance to halogen based corrosive substances is produced.

In the case where a plurality of kinds of AM oxides or AEM oxides are mixed as (AM)₂O or (AEM)O, they are mixed such that the total content is 2 to 18 mol%. As (AM)₂O, Na₂O and/or K₂O is particularly preferable.

The average particle diameter of the powder of the glass is preferably 0.1 to 10 µm. When the average particle diameter is equal to or more than 0.1 µm, the glass powder does not aggregate in the glass paste but is uniformly dispersed, so that control of the thickness of the glass coating layer is facilitated. When the average particle diameter is equal to or less than 10 µm, application property of the glass paste is improved, and surface smoothness of the glass coating layer can be secured properly.

As the organic solvent, for example, diethyleneglycol acetate monobutyl ether, terpineol, ethanol, and acetone can be preferably used either singly or as a mixture.

As the resin binder, one that does not contain a metallic element (a metallic element is absent in the molecular structure) and that can be removed by combustion at a temperature of equal to or less than 600°C is preferable; for example, ethyl cellulose and acrylic resins can be preferably used.

An example of the procedure of the glass paste preparing step S2a will be described. First, the resin binder is mixed with the organic solvent to produce a mixed solvent. The resin binder concentration in the mixed solvent (hereinafter referred to as a resin binder concentration) is preferably 3 to 13 mass%, more preferably 5 to 10 mass%. By adjusting the resin binder concentration to a value equal to or more than 3 mass%, the viscosity of the glass paste and adhesiveness to the metallic substrate can be secured, and, since the glass paste can properly remain on the flow path wall inner surface of the metallic substrate, a uniform glass coating layer can be formed in the next step S2b. On the other hand, by adjusting the resin binder concentration to a value equal to or less than 13 mass%, such a viscosity that the excessive glass paste can be discharged in the next step S2b can be realized.

Next, the glass powder is added to and mixed with the mixed solvent to produce the glass paste. The mixing ratio (solid matter concentration) of the glass powder in the glass paste is preferably 10 to 90 mass%, more preferably 20 to 80 mass%. By adjusting the solid matter concentration to a value equal to or more than 10 mass%, an amount of the glass for forming a sufficient glass coating layer in the next step S2b can be secured. In addition, by adjusting the solid matter concentration to a value equal to or less than 90 mass%, a uniform glass coating layer can be formed in the next step S2b, without a lowering in the fluidity of the glass paste or a lowering in adhesiveness to the metallic substrate.

The glass paste applying and baking step S2b is a step of applying the prepared glass paste to the inner surface of the flow path wall of the metallic substrate 10 and thereafter heating the glass paste together with the metallic substrate 10 to bake the glass coating layer 20. The method for applying the glass paste is not particularly limited; for example, a method in which the glass paste is jetted to the flow path wall inner surface by use of a spray gun to thereby be applied, a method of causing the glass paste to flow into the flow path and thereafter discharging an excess of the glass paste, a method of dip coating the metallic substrate 10 with the glass paste and thereafter discharging an excess of the glass paste, and the like can be used as required.

The heat treatment temperature for baking the glass coating layer 20 is preferably equal to or more than the softening point temperature of the glass used and equal to or less than 700°C. When the heat treatment temperature is less than the softening point temperature, the glass particles are not softened and fluidized, and the coating layer cannot be formed. When the heat treatment temperature exceeds 700°C, the metallic substrate 10 may be denatured.

Note that, in the present invention, the glass paste applying and baking step S2b is not limited to one time of application and one time of baking, and a combination of application and baking may be repeated multiple times. From the viewpoint of control of the thickness of the glass coating layer 20, a combination of application and baking is preferably repeated multiple times. In addition, it is also possible to prepare a plurality of kinds of glass pastes differing in glass composition or blending ratio, and repeat application and baking multiple times while changing the glass pastes.

### [Examples]

The present invention will be described further specifically by use of Examples and Comparative Examples. Note that the present invention is not limited to these Examples.

### [Experiment 1]

### (Test and Evaluation of Corrosion Resistance in Material)

Glass materials to be the glass coating layer and a metallic material to be the metallic substrate were subjected to a test and evaluation of corrosion resistance to hydrogen halide acids.

As glass materials, there were prepared a P₂O₅-ZnO-Al₂O₃ based glass (63 mol%P₂O₅-17 mol%ZnO-10 mol%Al₂O₃-10 mol%Na₂O, softening point 550°C), a Bi₂O₃-ZnO-B₂O₃ based glass (70 mol%Bi₂O₃-11 mol%B₂O₃-8 mol%ZnO-5 mol%SiO₂-4 mol%BaO-2 mol%CuO, softening point 510°C), an SiO₂-B₂O₃-Na₂O based glass (65 mol%SiO₂-10 mol%B₂O₃-7 mol%Na₂O-7 mol%Li₂O-4 mol%Al₂O₃-4 mol%K₂O, softening point 590°C), and a V₂O₃-TeO₂-Fe₂O₃ based glass (40 mol%V₂O₃-30 mol%TeO₂-15 mol%Fe₂O₃-15 mol%P₂O₅, softening point 390°C). In addition, as a metallic material, there was prepared SUS316L which is often used as a piping material for a supply gas line.

As a starting material of the glass materials, commercial reagents (each purity: 99.9%) of oxide powders of the above composition or commercial reagents (each purity: 99.9%) of carbonate powders of cation of oxides of the above composition were used. After mixing the starting materials to obtain a desired glass composition and melting the mixture in a glass melting furnace, the melt was made to flow into a stainless steel mold or a graphite mold, to produce bulks (each approximately 200 g) of the glass materials. Presumably from the purities of the starting materials, the glass materials in the present invention contain unavoidable impurities. As SUS316L of the metallic material, a commercial product was prepared.

From the thus prepared bulks of the glass materials and SUS316L of the metallic material, specimens (10 mm in length × 5 mm in width × 5 mm in thickness) for corrosion resistance test were taken out. The specimen of SUS316L was made to be a standard specimen for corrosion resistance.

As an acceleration test of corrosion resistance, each specimen was immersed in a predetermined test liquid for a predetermined time (5 hours, 25 hours). As the test liquid, there were prepared a 30 mass% hydrofluoric acid (temperature 25°C), a 10 mass% hydrochloric acid (temperature 60°C), and a 20 mass% hydrobromic acid (temperature 60°C). The mass difference before and after immersion of the specimen in the test liquid was divided by the surface area of the specimen before immersion, to determine the mass reduction amount (mg/mm²) per unit area.

When the mass reduction amount of a specimen was less than the mass reduction amount of the standard specimen SUS316L, the specimen was evaluated as "Good," while when the mass reduction amount of a specimen was equal to or more than the mass reduction amount of the standard specimen SUS316L, the specimen was determined as "Not good." The results are set forth in Tables 1 to 3.

**[Table 1]**

| Corrosion resistance to 30 mass% hydrofluoric acid | | | | |
|---|---|---|---|---|
| Specimen | Corrosion resistance to 30% HF aqueous solution (25°C) | | | |
| | Mass reduction amount upon 5 h immersion (mg/mm²) | Evaluation | Mass reduction amount upon 25 h immersion (mg/mm²) | Evaluation |
| P₂O₅-ZnO-Al₂O₃ based glass | 0.08 | Good | 0.30 | Good |
| Bi₂O₃-ZnO-B₂O₃ based glass | 0.06 | Good | 0.32 | Good |
| SiO₂-B₂O₃-Na₂O based glass | 2.8 | Not good | 13.7 | Not good |
| V₂O₃-TeO₂-Fe₂O₃ based glass | 3.2 | Not good | 15.8 | Not good |
| SUS316L | 0.16 | Standard | 0.72 | Standard |

**[Table 2]**

| Corrosion resistance to 10 mass% hydrochloric acid | | | | |
|---|---|---|---|---|
| Specimen | Corrosion resistance to 10% HCl aqueous solution (60°C) | | | |
| | Mass reduction amount upon 5 h immersion (mg/mm²) | Evaluation | Mass reduction amount upon 25 h immersion (mg/mm²) | Evaluation |
| P₂O₅-ZnO-Al₂O₃ based glass | 0.005 | Good | 0.02 | Good |
| Bi₂O₃-ZnO-B₂O₃ based glass | 2.6 | Not good | 13.0 | Not good |
| SiO₂-B₂O₃-Na₂O based glass | 0.000 | Good | 0.001 | Good |
| V₂O₃-TeO₂-Fe₂O₃ based glass | 1.5 | Not good | 7.8 | Not good |
| SUS316L | 0.17 | Standard | 0.38 | Standard |

**[Table 3]**

| Corrosion resistance to 20 mass% hydrobromic acid | | | | |
|---|---|---|---|---|
| Specimen | Corrosion resistance to 20% HBr aqueous solution (60°C) | | | |
| | Mass reduction amount upon 5 h immersion (mg/mm²) | Evaluation | Mass reduction amount upon 25 h immersion (mg/mm²) | Evaluation |
| P₂O₅-ZnO-Al₂O₃ based glass | 0.004 | Good | 0.020 | Good |
| Bi₂O₃-ZnO-B₂O₃ based glass | 1.8 | Not good | 10.8 | Not good |
| SiO₂-B₂O₃-Na₂O based glass | 0.000 | Good | 0.002 | Good |
| V₂O₃-TeO₂-Fe₂O₃ based glass | 0.25 | Not good | 1.3 | Not good |
| SUS316L | 0.005 | Standard | 0.025 | Standard |

As set forth in Tables 1 to 3, the P₂O₅-ZnO-Al₂O₃ based glass and the Bi₂O₃-ZnO-B₂O₃ based glass are better than SUS316L in corrosion resistance to hydrofluoric acid (30 mass% HF aqueous solution), and are determined as "Good." The P₂O₅-ZnO-Al₂O₃ based glass and the SiO₂-B₂O₃-Na₂O based glass are better than SUS316L in corrosion resistance to hydrochloric acid (10 mass% HCl aqueous solution), and are determined as "Good." The P₂O₅-ZnO-Al₂O₃ based glass and the SiO₂-B₂O₃-Na₂O based glass are better than SUS316L in corrosion resistance to hydrobromic acid (20 mass% HBr aqueous solution), and are determined as "Good."

### [Experiment 2]

### (Investigation of Variation in Roughness of Flow Path Wall Inner Surface of Gas Flow Path Member)

In the present experiment, a simple gas flow path member was produced, and a hydrogen halide gas was made to flow, to investigate variation in roughness of the flow path wall inner surface.

A metallic substrate (flow path inside diameter 10 mm, flow path length 250 mm) of SUS316L was produced by a metallic laminate shaping method (metallic laminate shaping step S1). As a comparative specimen, a commercial SUS316L pipe for gas supply line (flow path inside diameter 10 mm, flow path length 250 mm) was prepared. In addition, for investigation of microstructure, a SUS316L substrate by the metallic laminate shaping method and a commercial SUS316L pipe were prepared separately.

Note that various conditions in the metallic laminate shaping step S1 were set as follows.
(1) SUS316L powder: particle size 10 to 60 µm, median diameter 40 µm
(2) Laminate shaping apparatus: M290 manufactured by EOS GmbH Electro Optical Systems, Germany
(3) Laminate shaping conditions: laser power 300 W, scanning speed 800 mm/s, scanning pitch 0.1 mm, powder bed thickness 0.04 mm, argon atmosphere 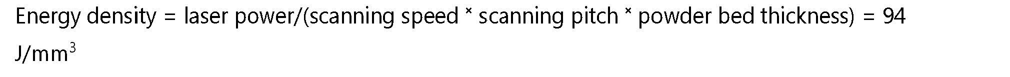 Energy density = laser power/(scanning speed × scanning pitch × powder bed thickness) = 94 J/mm3

The SUS316L substrate and the SUS316L pipe for investigation of microstructure were cut, and the inner surface roughness of the flow path was measured by a contact type surface roughness measuring machine (SURFTEST SV-3000 manufactured by Mitsutoyo Corporation). In the surface roughness measurement, according to ISO/JIS standards (ISO 4288:1996/JIS B 0633:2001), the measurement length (evaluation length) was 4 to 40 mm, and the reference length was 0.8 to 8 mm. As a result, the arithmetic mean roughnesses Ra of the SUS316L substrate and the SUS316L pipe were 20 µm and 0.4 µm.

For forming a glass coating layer on the flow path wall inner surface of the laminate shaped SUS316L substrate, a glass paste was prepared. The remainder upon taking out the specimen for corrosion resistance test in Experiment 1 was crushed by use of a stamp mill and a jet mill, to prepare a glass powder (average particle diameter 3 µm). A powder of a P₂O₅-ZnO-Al₂O₃ based glass, diethyleneglycol acetate monobutyl ether (BCA) as an organic solvent, and ethyl cellulose (EC) as a resin binder were mixed, to produce a glass paste (glass paste preparing step S2a).

Next, the glass paste was applied to the flow path wall inner surface of the SUS316L substrate by use of a spray gun, and was baked at 600°C, to form a glass coating layer (glass paste applying and baking step S2b). In this instance, the number of repetition times of the application and baking of the glass paste was controlled, to produce a plurality of kinds of metal additive shaped flow path member specimens differing in the average thickness of the glass coating layer. In addition, specimens for microstructure investigation were also produced.

For the specimens for microstructure investigation, the relation between the surface roughness of the flow path wall inner surface and the microstructure was investigated. The surface roughness measurement of the flow path wall inner surface with the glass coating layer formed was performed similarly to the case described above, and microstructure observation was performed by use of a scanning electron microscope (SEM).

It was confirmed that metallic laminate shaped flow path members of 2.5 µm, 1.2 µm, 0.5 µm, 0.4 µm, and 0.2 µm in the arithmetic mean roughness Ra were obtained. As a result of microstructure observation, the specimens having the arithmetic mean roughness Ra of equal to or more than 0.5 µm had a skin of the SUS316L substrate confirmed on the flow path wall inner surface. In other words, the specimens having the arithmetic mean roughness Ra of equal to or more than 0.5 µm retained regions not covered with the glass coating layer in projected parts of the surface irregularities of the metallic substrate (regions where recessed parts of the surface irregularities of the metallic substrate were not completely filled with the glass coating layer). On the other hand, in the specimens having an arithmetic mean roughness Ra of equal to or less than 0.4 µm, a skin of the SUS316L substrate was not confirmed on the flow path wall inner surface (recessed parts of the surface irregularities of the metallic substrate were deemed to be completely filled with the glass coating layer).

A test was conducted in which an HCl gas (temperature 100°C) was made to flow through the prepared metallic laminate shaped flow path member and the commercial SUS316L pipe for 100 hours, and thereafter N₂ (nitrogen) gas was made to flow therethrough for five minutes to purge the HCl gas in the flow path. Each specimen after the test was cut, and the arithmetic mean roughness Ra of the flow path wall inner surface was measured similarly to the case described above. A case where the arithmetic mean roughness Ra was not changed before and after the test was determined as "Acceptable," and a case where the arithmetic mean roughness Ra was changed was determined as "Unacceptable." The results are set forth in Table 4.

**[Table 4]**

| Change in surface roughness due to distribution of HCl gas | | | |
|---|---|---|---|
| Specimen | Arithmetic mean roughness Ra | | Evaluation |
| | Before HCl gas distribution | After HCl gas distribution | |
| SUS316L pipe | 0.4 | 0.6 | Unacceptable |
| Metallic laminate shaped flow path member | 2.5 | 2.3 | Unacceptable |
| | 1.2 | 1.0 | Unacceptable |
| | 0.5 | 0.4 | Unacceptable |
| | 0.4 | 0.4 | Acceptable |
| | 0.2 | 0.2 | Acceptable |

As set forth in Table 4, the commercial SUS316L pipe had an increased surface roughness of the gas contact surface after HCl gas distribution test. This is considered to be due to corrosion generated by distribution of the HCl gas. On the other hand, in the specimens of the laminate shaped flow path member having an initial arithmetic mean roughness Ra of equal to or more than 0.5 µm, the surface roughness of the gas contact surface was reduced after the HCl gas distribution test. It is considered that, because only the skin of the SUS316L substrate in the projected parts on the gas contact surface was corroded due to distribution of the HCl gas, the surface roughness of the gas contact surface was apparently reduced. In either case, the surface roughness is changed before and after the HCl gas distribution test, the commercial SUS316L pipe and the specimens of the laminate shaped flow path member having an initial arithmetic mean roughness Ra of equal to or more than 0.5 µm are determined as "Unacceptable."

On the other hand, the specimens of the laminate shaped flow path member having an initial arithmetic mean roughness Ra of equal to or less than 0.4 µm are not changed in surface roughness before and after the HCl gas distribution test and, therefore, are determined as "Acceptable." These results are considered to arise from whether or not the skin of the metallic substrate insufficient in corrosion resistance is exposed on the flow path wall inner surface (whether or not the recessed parts of the surface irregularities of the metallic substrate are completely covered with the glass coating layer). In addition, it was separately confirmed that the laminate shaped flow path members determined as Acceptable are high in cleaning effect on the gas line. Besides, they are considered to be effective for shortening the vacuum reaching time in the semiconductor manufacturing apparatus.

### [Experiment 3]

### (Detailed Investigation of P₂O₅-ZnO-Al₂O₃ Based Glass)

In Experiment 1, the P₂O₅-ZnO-Al₂O₃ based glass exhibited favorable corrosion resistance to all the three hydrogen halide acids (HF aq., HCl aq., HBr aq.) (see Tables 1 to 3). In view of this, in the present experiment, more detailed investigation of the P₂O₅-ZnO-Al₂O₃ based glass was conducted.

As the glass material, the P₂O₅-ZnO-Al₂O₃-(AM)₂O glass and the P₂O₅-ZnO-Al₂O₃-(AEM)O glass (AEM is an alkaline earth metal) were prepared. Similarly to Experiment 1, glass materials G-01 to G-42 (each approximately 200 g) having the chemical compositions as set forth in Tables 5 and 6 to be described later were produced, and specimens for corrosion resistance test (10 mm in length × 5 mm in width × 5 mm in thickness) were taken out therefrom.

Next, for evaluating the corrosion resistance of each glass material, similarly to Experiment 1, an acceleration test in which the specimens were immersed in test liquids of 30 mass% HF aq. (temperature 25°C), 10 mass% HCl aq. (temperature 60°C), and 20 mass% HBr aq. (temperature 60°C) for a predetermined time (25 hours) was conducted, and the mass reduction amount (mg/mm²) per unit area of each specimen was determined.

A case where the mass reduction amount of the glass material in any one of the three kinds of test liquids (HF aq., HCl aq., HBr aq.) is less than that of the standard material was evaluated as "Good," and a case where the mass reduction amount in all of the three kinds of test liquids is less than that of the standard material was evaluated as "Excellent." The results of corrosion resistance are set forth in Tables 5 and 6.

**[Table 5]**

| Chemical compositions and results of corrosion resistance of glass materials G-01 to G-38 | | | | | | | | | |
|---|---|---|---|---|---|---|---|---|---|
| Glass material | Chemical composition (mol%) | | | | | Mass reduction amount (mg/mm²) | | | |
| | P₂O₅ | ZnO | Al₂O₃ | (AM)₂O | | HF | HCl | HBr | Evaluation |
| | | | | Na₂O | K₂O | | | | |
| G-01 | 45 | 20 | 20 | 15 | - | 0.79 | 0.074 | 0.030 | Good |
| G-02 | 49 | 19 | 18 | 14 | - | 0.73 | 0.052 | 0.026 | |
| G-03 | 51 | 18 | 18 | 13 | - | 0.68 | 0.033 | 0.023 | Excellent |
| G-04 | 55 | 18 | 17 | 10 | - | 0.41 | 0.028 | 0.024 | |
| G-05 | 59 | 17 | 16 | 8 | - | 0.51 | 0.035 | 0.022 | |
| G-06 | 65 | 15 | 15 | 5 | - | 0.78 | 0.083 | 0.029 | Good |
| G-07 | 60 | 10 | 14 | 16 | - | 0.85 | 0.068 | 0.031 | |
| G-08 | 58 | 14 | 16 | 12 | - | 0.73 | 0.047 | 0.027 | |
| G-09 | 57 | 16 | 17 | 10 | - | 0.37 | 0.024 | 0.022 | Excellent |
| G-10 | 56 | 19 | 16 | 9 | - | 0.58 | 0.032 | 0.024 | |
| G-11 | 56 | 21 | 16 | 7 | - | 0.73 | 0.059 | 0.026 | Good |
| G-12 | 58 | 25 | 12 | 5 | - | 0.89 | 0.091 | 0.041 | |
| G-13 | 58 | 21 | 10 | 11 | - | 0.94 | 0.088 | 0.037 | |
| G-14 | 57 | 17 | 16 | 10 | - | 0.31 | 0.021 | 0.020 | Excellent |
| G-15 | 56 | 16 | 19 | 9 | - | 0.45 | 0.032 | 0.024 | |
| G-16 | 55 | 16 | 21 | 8 | - | 0.72 | 0.048 | 0.025 | Good |
| G-17 | 50 | 20 | 25 | 5 | - | 0.79 | 0.063 | 0.036 | |
| G-18 | 58 | 20 | 20 | 2 | - | 0.93 | 0.063 | 0.035 | |
| G-19 | 58 | 19 | 19 | 4 | - | 0.73 | 0.052 | 0.025 | |
| G-20 | 57 | 19 | 18 | 6 | - | 0.55 | 0.046 | 0.024 | Excellent |
| G-21 | 55 | 18 | 17 | 10 | - | 0.46 | 0.038 | 0.023 | |
| G-22 | 54 | 16 | 16 | 14 | - | 0.57 | 0.048 | 0.024 | |
| G-23 | 52 | 16 | 16 | 16 | - | 0.73 | 0.063 | 0.025 | Good |
| G-24 | 52 | 15 | 15 | 18 | - | 0.95 | 0.072 | 0.042 | |
| G-25 | 58 | 20 | 20 | - | 2 | 0.91 | 0.064 | 0.036 | |
| G-26 | 58 | 19 | 19 | - | 4 | 0.73 | 0.050 | 0.025 | |
| G-27 | 57 | 19 | 18 | - | 6 | 0.54 | 0.047 | 0.024 | Excellent |
| G-28 | 55 | 18 | 17 | - | 10 | 0.45 | 0.039 | 0.023 | |
| G-29 | 54 | 16 | 16 | - | 14 | 0.56 | 0.047 | 0.024 | |
| G-30 | 52 | 16 | 16 | - | 16 | 0.73 | 0.065 | 0.025 | Good |
| G-31 | 52 | 15 | 15 | - | 18 | 0.93 | 0.074 | 0.043 | |
| G-32 | 58 | 20 | 20 | 1 | 1 | 0.88 | 0.064 | 0.035 | |
| G-33 | 58 | 19 | 19 | 2 | 2 | 0.73 | 0.049 | 0.025 | |
| G-34 | 57 | 19 | 18 | 3 | 3 | 0.51 | 0.047 | 0.024 | Excellent |
| G-35 | 55 | 18 | 17 | 5 | 5 | 0.41 | 0.035 | 0.020 | |
| G-36 | 54 | 16 | 16 | 7 | 7 | 0.52 | 0.047 | 0.024 | |
| G-37 | 52 | 16 | 16 | 8 | 8 | 0.73 | 0.064 | 0.025 | Good |
| G-38 | 52 | 15 | 15 | 9 | 9 | 0.91 | 0.073 | 0.043 | |
| SUS316L | | | | | | 0.72 | 0.38 | 0.025 | Standard |

| | | | | | | | | | |
|---|---|---|---|---|---|---|---|---|---|
| -: indicates that the component was not intentionally contained. Note that Glass materials G-06, G-07, G-12, G-13, G-24, G-31 and G-38 are comparative examples not covered by the invention. | | | | | | | | | |

**[Table 6]**

| Chemical compositions and results of corrosion resistance of glass materials G-39 to G-42 | | | | | | | | |
|---|---|---|---|---|---|---|---|---|
| Glass material | Chemical composition (mol%) | | | | Mass reduction amount (mg/mm²) | | | |
| | P₂O₅ | ZnO | Al₂O₃ | (AEM)O | HF | HCl | HBr | Evaluation |
| G-39 | 56 | 17 | 17 | MgO = 10 | 0.79 | 0.033 | 0.028 | Good |
| G-40 | 56 | 17 | 17 | CaO = 10 | 0.82 | 0.040 | 0.033 | |
| G-41 | 56 | 17 | 17 | SrO = 10 | 0.59 | 0.047 | 0.040 | |
| G-42 | 56 | 17 | 17 | BaO = 10 | 1.10 | 0.043 | 0.035 | |
| SUS316L | | | | | 0.72 | 0.38 | 0.025 | Standard |

As set forth in Tables 5 and 6, the glass materials G-01, G-02, G-06 to G-08, G-11 to G-13, G-16 to G-19, G-23 to G-26, G-30 to G-33, G-37, and G-38 of the P₂O₅-ZnO-Al₂O₃-(AM)₂O, and the glass materials G-39 to G-42 of the P₂0₅-ZnO-Al₂O₃-(AEM)O have the mass reduction amount in the test liquid of HCl aq. of equal to or less than a quarter of that of the standard material, and are evaluated as "Good."

In addition, the glass materials G-03 to G-05, G-09, G-10, G-14, G-15, G-20 to G-22, G-27 to G-29, and G-34 to G-36 of the P₂O₅-ZnO-Al₂O₃-(AM)₂O have the mass reduction amount in all of the three kinds of test liquids less than that of the standard material, and are evaluated as "Excellent." The glass materials evaluated as Excellent have a chemical composition including, in terms of oxide, 51 to 63 mol% of P₂O₅, 16 to 19 mol% of ZnO, 10 to 19 mol% of Al₂O₃, and 6 to 14 mol% of (AM)₂O.

### [Experiment 4]

### (Conditions of Glass Paste and Investigation of Roughness of Flow Path Wall Inner Surface)

In the present experiment, a simple gas flow path member was produced while changing glass paste conditions, and a hydrogen halide gas was made to flow therethrough, to investigate change in roughness of the flow path wall inner surface.

Similarly to Experiment 2, a metallic substrate (U-shaped flow path pipe, flow path inside diameter 4.35 mm, U-shaped section radius of curvature 22.5 mm, straight section length 50 mm, flow path total length 150 mm) of SUS316L was produced by a metallic laminate shaping method (metallic laminate shaping step S1). In addition, a metallic substrate for microstructure investigation was separately prepared.

For forming a glass coating layer on the flow path wall inner surface of the laminate shaped metallic substrate, a glass paste was prepared.

First, the remainder of G-09 upon taking out the specimen for corrosion resistance test in Experiment 3 was crushed by use of a stamp mill and a jet mill, to prepare a glass powder (average particle diameter 5 µm). After EC as a resin binder was added to 50 g of BCA as an organic solvent, mixing was conducted by use of a planetary centrifugal mixer (ARE-310 manufactured by THINKY CORPORATION), to produce mixed solvents differing in resin binder concentration (resin binder concentration = 1 to 15 mass%).

To these mixed solvents, the powder of the glass material G-10 in Table 1 was added such that the mixing ratio (solid matter concentration) of the glass powder in the glass paste was 60 mass%, after which mixing was conducted by use of the above-mentioned planetary centrifugal mixer to produce a glass paste (glass paste producing step S2a).

Next, the glass paste was made to flow into the flow path of the metallic substrate, and thereafter, an excess of the glass paste was discharged by use of a squeegee separately produced according to the flow path shape of the metallic substrate. After the glass paste was applied to the flow path wall inner surface, baking was conducted at 600°C, to form the glass coating layer (glass paste applying and baking step S2b), and the specimen of the metallic laminate shaped flow path member was produced.

The produced metallic laminate shaped flow path member and the metallic substrate as a single body were cut, and the roughness measurement and microstructure observation of the flow path wall inner surface were conducted. The surface roughness was measured by use of a contact type surface roughness measuring machine (SURFTEST SV-3000 manufactured by Mitsutoyo Corporation). In the surface roughness measurement, according to ISO/JIS standards (ISO 4288:1996/JIS B 0633:2001), the measurement length (evaluation length) was 4 to 40 mm, and the reference length was 0.8 to 8 mm. The results of roughness measurement of the flow path wall inner surface are set forth in Table 7.

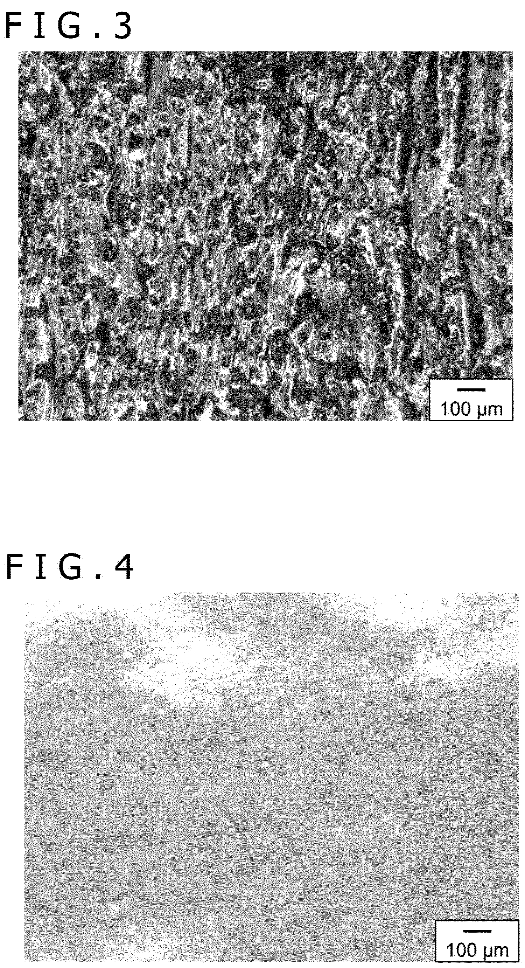

The microstructure observation was conducted by use of a digital microscope (VHX-1000 manufactured by Keyence Corporation). FIG. 3 is a photograph of a microstructure of the flow path wall inner surface of the metallic substrate on which a glass coating layer has not been formed, and FIG. 4 is a photograph of a microstructure of the flow path wall inner surface of an example of the metallic laminate shaped flow path member on which a glass coating layer has been formed.

**[Table 7]**

| Results of roughness measurement of flow path wall inner surface of flow path member and metallic substrate | | |
|---|---|---|
| | Resin binder concentration in mixed solvent | Arithmetic mean roughness Ra (µm) |
| Flow path member | 1 mass% | 0.92 |
| | 3 mass% | 0.39 |
| | 5 mass% | 0.31 |
| | 7 mass% | 0.25 |
| | 10 mass% | 0.29 |
| | 13 mass% | 0.38 |
| | 15 mass% | 0.87 |
| Metallic substrate | Without glass coating layer | 8.9 |

As set forth in Table 7, the arithmetic mean roughness Ra of the flow path wall inner surface of the metallic substrate on which a glass coating layer has not been formed is 8.9 µm. In addition, from FIG. 3, also, it is confirmed that the flow path wall inner surface of the metallic substrate is formed with large irregularities.

On the other hand, Ra of the flow path wall inner surface of the metallic laminate shaped flow path member on which a glass coating layer has been formed is equal to or less than 1/10. In addition, from FIG. 4, it is confirmed that the flow path wall inner surface of the metallic laminate shaped flow path member is remarkably enhanced in surface smoothness due to the formation of the glass coating layer. Note that the specimen depicted in FIG. 4 is a specimen in which the resin binder concentration in the mixed solvent is 7 mass%.

It is to be noted, however, that, when the resin binder concentration in the mixed solvent used in the glass paste producing step is less than 3 mass% or more than 13 mass% as set forth in Table 7, Ra of the flow path wall inner surface exceeds 0.4 µm which is desirable as the flow path member. In other words, it is confirmed that the resin binder concentration in the mixed solvent when producing the glass paste is preferably 3 to 13 mass%.

The aforementioned Examples and Experiments have been described for assisting understanding of the present invention, and the present invention is not limited to only the described specific configuration. For example, a part of the configuration of the embodiment can be replaced by the configuration according to technical common sense of those skilled in the art, and the configuration according to the technical common sense of those skilled in the art can be added to the configuration of the embodiment. In other words, the present invention permits deletion, replacement by other configuration, and addition of other configuration, in regard of a part of the configurations of the embodiment and experiments in the present description, in such a range as not to depart from the technical thought of the present invention as defined in the independent claims 1 and 6.

### Description of Reference Characters

100: Metallic laminate shaped flow path member
10: Metallic substrate
20: Glass coating layer

## Claims

1. A metallic laminate shaped flow path member through which to distribute a corrosive fluid, the corrosive fluid is HF, HCl, or HBr,
wherein a metallic substrate constituting the metallic laminate shaped flow path member has surface irregularities having an arithmetic mean roughness Ra from 5 to 50 µm,
an inner surface of a flow path wall of the metallic laminate shaped flow path member is formed with a glass coating layer in such a manner as to fill at least recessed regions of the surface irregularities of the metallic substrate so that an arithmetic mean roughness Ra of the inner surface is equal to or less than 0.4 µm, and
the glass coating layer includes a layer of a P₂O₅-ZnO-Al₂O₃ based glass,
**characterized in that** the P₂O₅-ZnO-Al₂O₃ based glass is a P₂O₅-ZnO-Al₂O₃-(AM)₂O glass (AM is an alkali metal) or a P₂O₅-ZnO-Al₂O₃-(AEM)0 glass (AEM is an alkaline earth metal), and the P₂O₅-ZnO-Al₂O₃-(AM)₂O glass or the P₂O₅-ZnO-Al₂O₃-(AEM)O glass has a chemical composition consisting of, in terms of respective oxide, 45 to 65 mol% of P₂O₅, 10 to 25 mol% of ZnO, 16 to 25 mol% of Al₂O₃, and 2 to 18 mol% of (AM)₂O or (AEM)O, and unavoidable impurities.

2. The metallic laminate shaped flow path member according to claim 1,
wherein the P₂O₅-ZnO-Al₂O₃ based glass is a P₂O₅-ZnO-Al₂O₃-(AM)₂O glass (AM is an alkali metal), and
the P₂O₅-ZnO-Al₂O₃-(AM)₂O glass has a chemical composition including, in terms of oxide, 51 to 63 mol% of P₂O₅, 16 to 19 mol% of ZnO, 16 to 19 mol% of Al₂O₃, and 6 to 14 mol% of (AM)₂O.

3. The metallic laminate shaped flow path member according to claim 2,
wherein the (AM)₂O is at least one kind of Na₂O and K₂O.

4. The metallic laminate shaped flow path member according to any one of claims 1 to 3,
wherein the metallic laminate shaped flow path member has at least one kind of structures of a branched flow path, a joining flow path, a constriction flow path, and a spiral flow path.

5. The metallic laminate shaped flow path member according to any one of claims 1 to 4,
wherein the metallic substrate includes any one of stainless steel, a Ni-Cr-Mo based alloy, and a Co-Cr-Fe-Ni-Ti based alloy.

6. A method of manufacturing the metallic laminate shaped flow path member according to any one of claims 1 to 5, the method comprising:
a metallic laminate shaping step of forming the metallic substrate by a metallic laminate shaping method; and
a glass coating layer forming step of forming the glass coating layer on the inner surface of the flow path wall,
wherein the glass coating layer forming step includes
a glass paste preparing step of preparing a glass paste in which a powder of the glass, a resin binder, and an organic solvent are mixed, and
a glass paste applying and baking step of applying the glass paste to the inner surface of the flow path wall and heat treating the glass paste together with the metallic substrate to bake the glass coating layer, and
a temperature of the heat treatment in the glass paste applying and baking step is equal to or more than a softening point temperature of the glass and equal to or less than 700°C.

7. The method of manufacturing the metallic laminate shaped flow path member according to claim 6,
wherein the glass paste has a content of the resin binder based on a total of the organic solvent and the resin binder being 3 to 13 mass%, and a content of the powder of the glass in the glass paste is 10 to 90 mass%.

## Patentansprüche

1. Metallisches laminatgeformtes Fließwegelement, durch das eine korrosive Flüssigkeit verteilt werden soll, wobei die korrosive Flüssigkeit HF, HCl oder HBr ist,
wobei ein das metallische laminatgeformte Fließwegelement bildendes metallisches Substrat Oberflächenunebenheiten mit einer Rauheit Ra von 5 bis 50 µm im arithmetischen Mittel aufweist,
eine Innenfläche einer Fließwegwand des metallischen laminatgeformten Fließwegelements mit einer Glasüberzugschicht derart ausgebildet ist, dass mindestens vertiefte Bereiche der Oberflächenunebenheiten des metallischen Substrats gefüllt werden, so dass eine arithmetische Mittenrauheit Ra der Innenfläche gleich oder kleiner als 0,4 µm ist, und
die Glasüberzugschicht eine Schicht aus einem P₂O₅-ZnO-Al₂O₃-basierten Glas umfasst,
**dadurch gekennzeichnet, dass** das P₂O₅-ZnO-Al₂O₃-basierte Glas ein P₂O₅-ZnO-Al₂O₃-(AM)₂O-Glas (AM ist ein Alkalimetall) oder ein P₂O₅-ZnO-Al₂O₃-(AEM)O-Glas (AEM ist ein Erdalkalimetall) ist, und das P₂O₅-ZnO-Al₂O₃-(AM)₂O-Glas oder das P₂O₅-ZnO-Al₂O₃-(AEM)O-Glas eine chemische Zusammensetzung aufweist, die, ausgedrückt als jeweiliges Oxid, aus 45 bis 65 mol% P₂O₅, 10 bis 25 mol% ZnO, 16 bis 25 mol% Al₂O₃ und 2 bis 18 mol% (AM)₂O oder (AEM)O sowie unvermeidbaren Verunreinigungen besteht.

2. Metallisches laminatgeformtes Fließwegelement nach Anspruch 1,
wobei das P₂O₅-ZnO-Al₂O₃-basierte Glas ein P₂O₅-ZnO-Al₂O₃-(AM)₂O-Glas (AM ist ein Alkalimetall) ist, und
das P₂O₅-ZnO-Al₂O₃-(AM)₂O-Glas eine chemische Zusammensetzung aufweist, die, ausgedrückt als Oxid, 51 bis 63 mol% P₂O₅, 16 bis 19 mol% ZnO, 16 bis 19 mol% Al₂O₃ und 6 bis 14 mol% (AM)₂O umfasst.

3. Metallisches laminatgeformtes Fließwegelement nach Anspruch 2,
wobei das (AM)₂O mindestens eine Art von Na₂O und K₂O ist.

4. Metallisches laminatgeformtes Fließwegelement nach einem der Ansprüche 1 bis 3,
wobei das metallische laminatgeformte Fließwegelement mindestens eine Art von Strukturen aus einem verzweigten Fließweg, einem zusammenführenden Fließweg, einem verengten Fließweg und einem spiralförmigen Fließweg aufweist.

5. Metallisches laminatgeformtes Fließwegelement nach einem der Ansprüche 1 bis 4,
wobei das metallische Substrat eine von rostfreiem Stahl, einer Ni-Cr-Mo-basierten Legierung und einer Co-Cr-Fe-Ni-Ti-basierten Legierung umfasst.

6. Verfahren zur Herstellung des metallischen laminatgeformten Fließwegelements nach einem der Ansprüche 1 bis 5, wobei das Verfahren umfasst:
einen metallischen Laminatformungsschritt zum Bilden des metallischen Substrats durch ein metallisches Laminatformungsverfahren; und
einen Glasüberzugschicht-Bildungsschritt zum Bilden der Glasüberzugschicht auf der Innenfläche der Fließwegwand,
wobei der Glasüberzugschicht-Bildungsschritt einen Glaspasten-Herstellungsschritt zum Herstellen einer Glaspaste, in der ein Pulver des Glases, ein Harzbindemittel und ein organisches Lösungsmittel gemischt sind, umfasst, und
einen Glaspasten-Auftrag- und -Brennschritt zum Auftragen der Glaspaste auf die Innenfläche der Fließwegwand und Wärmebehandlung der Glaspaste zusammen mit dem metallischen Substrat zum Brennen der Glasüberzugschicht, und
eine Temperatur der Wärmebehandlung im Glaspasten-Auftrag- und -Brennschritt gleich oder größer als eine Erweichungspunkttemperatur des Glases und gleich oder kleiner als 700°C ist.

7. Verfahren zur Herstellung des metallischen laminatgeformten Fließwegelements nach Anspruch 6,
wobei die Glaspaste einen Gehalt des Harzbindemittels basierend auf einer Gesamtmenge des organischen Lösungsmittels und des Harzbindemittels von 3 bis 13 Masse-% aufweist, und ein Gehalt des Pulvers des Glases in der Glaspaste 10 bis 90 Masse-% beträgt.

## Revendications

1. Élément de chemin d'écoulement profilé en stratifié métallique à travers lequel distribuer un fluide corrosif, le fluide corrosif est HF, HCl, ou HBr,
dans lequel un substrat métallique constituant l'élément de chemin d'écoulement profilé en stratifié métallique a des irrégularités de surface ayant une rugosité arithmétique moyenne Ra de 5 à 50 µm,
une surface intérieure d'une paroi de chemin d'écoulement de l'élément de chemin d'écoulement profilé en stratifié métallique est formée avec une couche de revêtement de verre de manière à remplir au moins des régions en renfoncement des irrégularités de surface du substrat métallique de telle sorte qu'une rugosité arithmétique moyenne Ra de la surface intérieure est égale ou inférieure à 0,4 µm, et
la couche de revêtement de verre inclut une couche d'un verre à base de P₂O₅-ZnO-Al₂O₃,
**caractérisé en ce que** le verre à base de P₂O₅-ZnO-Al₂O₃ est un verre de P₂O₅-ZnO-Al₂O₃-(AM)₂O (AM est un métal alcalin) ou un verre de P₂O₅-ZnO-Al₂O₃-(AEM)O (AEM est un métal alcalino-terreux), et le verre de P₂O₅-ZnO-Al₂O₃-(AM)₂O ou le verre de P₂O₅-ZnO-Al₂O₃-(AEM)O a une composition chimique consistant en, en termes d'oxyde respectif, 45 à 65% molaire de P₂O₅, 10 à 25% molaire de ZnO, 16 à 25% molaire de Al₂O₃, et 2 à 18% molaire de (AM)₂O ou (AEM)O, et des impuretés inévitables.

2. Élément de chemin d'écoulement profilé en stratifié métallique selon la revendication 1,
dans lequel le verre à base de P₂O₅-ZnO-Al₂O₃ est un verre de P₂O₅-ZnO-Al₂O₃-(AM)₂O (AM est un métal alcalin), et
le verre de P₂O₅-ZnO-Al₂O₃-(AM)₂O a une composition chimique incluant, en termes d'oxyde, 51 à 63% molaire de P₂O₅, 16 à 19% molaire de ZnO, 16 à 19% molaire de Al₂O₃, et 6 à 14% molaire de (AM)₂O.

3. Élément de chemin d'écoulement profilé en stratifié métallique selon la revendication 2,
dans lequel le (AM)₂O est au moins une espèce parmi Na₂O et K₂O.

4. Élément de chemin d'écoulement profilé en stratifié métallique selon l'une quelconque des revendications 1 à 3,
dans lequel l'élément de chemin d'écoulement profilé en stratifié métallique a au moins un type de structures parmi un chemin d'écoulement ramifié, un chemin d'écoulement de jonction, un chemin d'écoulement de constriction, et un chemin d'écoulement en spirale.

5. Élément de chemin d'écoulement profilé en stratifié métallique selon l'une quelconque des revendications 1 à 4,
dans lequel le substrat métallique inclut l'un quelconque parmi un acier inoxydable, un alliage à base de Ni-Cr-Mo, et un alliage à base de Co-Cr-Fe-Ni-Ti.

6. Procédé de fabrication de l'élément de chemin d'écoulement profilé en stratifié métallique selon l'une quelconque des revendications 1 à 5, le procédé comprenant :
une étape de profilage de stratifié métallique pour former le substrat métallique par un procédé de profilage de stratifié métallique ; et
une étape de formation de couche de revêtement de verre pour former la couche de revêtement de verre sur la surface intérieure de la paroi de chemin d'écoulement,
dans lequel l'étape de formation de couche de revêtement de verre inclut
une étape de préparation de pâte de verre pour préparer une pâte de verre dans laquelle une poudre du verre, un liant résineux, et un solvant organique sont mélangés, et
une étape d'application et de cuisson de pâte de verre pour appliquer la pâte de verre à la surface intérieure de la paroi de chemin d'écoulement et traiter thermiquement la pâte de verre ensemble avec le substrat métallique pour cuire la couche de revêtement de verre, et
une température du traitement thermique à l'étape d'application et de cuisson de pâte de verre est égale ou supérieure à une température de point de ramollissement du verre et égale ou inférieure à 700°C.

7. Procédé de fabrication de l'élément de chemin d'écoulement profilé en stratifié métallique selon la revendication 6,
dans lequel la pâte de verre a une teneur du liant résineux sur la base d'un total du solvant organique et du liant résineux étant 3 à 13% en masse, et une teneur de la poudre du verre dans la pâte de verre est 10 à 90% en masse.
